# EUROPÄISCHE PATENTSCHRIFT

(11) **EP 3 152 025 B1**
(45) Veröffentlichungstag und Bekanntmachung des Hinweises auf die Patenterteilung: **11.03.2020**
(21) Anmeldenummer: 15730416.3
(22) Anmeldetag: 02.06.2015
(51) Int. Cl.: B29C 33/42, B23K 26/36, B29C 59/02, B29C 37/00, C25D 11/18, C25D 11/26, C25D 11/16, B29C 35/02, B29C 35/08, B23K 26/361, B29K 105/16, B29L 7/00, C22F 1/04, C22F 1/18, C25D 11/12, B29C 45/37

(54) **VERFAHREN ZUR HERSTELLUNG EINES FORMWERKZEUGS**
METHOD FOR THE PRODUCTION OF A MOLD
PROCÉDÉ DE FABRICATION D'UN MOULE

(30) Priorität: 05.06.2014 DE 102014210798
(43) Veröffentlichungstag der Anmeldung: 12.04.2017
(73) Patentinhaber: Fraunhofer Gesellschaft zur Förderung der angewandten Forschung E.V., 80686 München (DE)
(72) Erfinder: HEILMANN, Andreas, 09573 Augustusburg (DE); THORMANN, Annika, 06108 Halle (DE)
(74) Vertreter: Friese Goeden Patentanwälte PartGmbB
(86) Internationale Anmeldenummer: PCT/EP2015/062238
(87) Internationale Veröffentlichungsnummer: WO 2015/185540

(56) Entgegenhaltungen:
- EP-A1- 2 286 980
- EP-A1- 2 286 981
- EP-A1- 2 289 708
- WO-A1-2008/048913
- WO-A1-2009/029435
- DE-C1- 10 020 877
- DE-U1- 20 006 010
- US-A1- 2003 071 016
- US-A1- 2007 035 056
- US-A1- 2008 233 404
- US-A1- 2011 086 204
- US-A1- 2013 140 744
- HYUN SUP LEE ET AL: "Replication of nanostructures on microstructures by intermediate film mold inserted hot embossing process", MICROSYSTEM TECHNOLOGIES ; MICRO AND NANOSYSTEMS INFORMATION STORAGE AND PROCESSING SYSTEMS, SPRINGER, BERLIN, DE, Bd. 14, Nr. 8, 5. März 2008 (2008-03-05), Seiten 1149-1155, XP019632912, ISSN: 1432-1858

## Beschreibung

Die Erfindung betrifft ein Verfahren zur Herstellung einer Oberflächenstrukturierung, insbesondere auf einem Formwerkzeug, wobei in einem ersten Verfahrensschritt erste Strukturelemente durch Laserstrukturierung erzeugt werden. Ein solches Formwerkzeug kann zum Heißprägen einer Kunststofffolie verwendet werden, bei welchem zumindest die Oberfläche der Kunststofffolie mit einem Farbstoff versehen wird, durch Absorption elektromagnetischer Strahlung zumindest ein Teil der Kunststofffolie über eine Verformungstemperatur erwärmt und nachfolgend mit einem solchen Formwerkzeug umgeformt wird.

Kunststofffolien und Formwerkzeuge zu deren Strukturierung sind aus der US 8,021,628 B2 bekannt. Das verwendete Formwerkzeug weist eine in etwa zylinderförmige Grundform auf, wobei die Mantelfläche mit einer Strukturierung versehen ist. Sofern eine Polymerschmelze oder eine bis zur Erweichung erwärmte Folie mit dem Werkzeug in Kontakt kommt, so wird eine zur Strukturierung des Werkzeuges komplementäre Form in die Oberfläche des Kunststoffes geprägt.

Das Formwerkzeug und die damit hergestellten Kunststoffbauteile weisen jedoch den Nachteil auf, dass sehr kleine Oberflächenstrukturierungen von weniger als 1 µm oder weniger als 100 nm nicht hergestellt werden können.

Aus der DE 100 20 877 C1 ist ein Prägewerkzeug bekannt, welches eine strukturierte Prägefläche mit einer anodisch oxidierten Oberflächenschicht aufweist. Dadurch wird kostengünstiges Prägen kleiner Strukturen ermöglicht.

Die WO 2009/029435 A1 offenbart Prägeformen aus Silikon, mit welchen Artikel wie Retroreflektoren, Beugungsgitter oder Fresnellinsen gefertigt werden können.

Ausgehend vom Stand der Technik liegt der Erfindung somit die Aufgabe zugrunde, ein Verfahren zur Herstellung eines Formwerkzeug anzugeben, welches sowohl erste Strukturelemente aufweist als auch zweite Strukturelemente, wobei die zweiten Strukturelemente eine geringere laterale Ausdehnung und/oder eine geringere Tiefe aufweisen als die ersten Strukturelemente.

Die Aufgabe wird erfindungsgemäß durch ein Verfahren gemäß Anspruch 1 gelöst.

Erfindungsgemäß wird ein Verfahren zur Herstellung eines Formwerkzeugs vorgeschlagen, bei welchem die Oberflächenstrukturierung und damit die Negativform der gewünschten Oberflächenstrukturierung des fertigen Bauteils in einem zweistufigen Verfahren hergestellt wird. Im ersten Verfahrensschritt werden erste Strukturelemente mit vergleichsweise großer lateraler Ausdehnung und/oder Tiefe erzeugt. Daran anschließend werden in einem zweiten Verfahrensschritt zweite Strukturelemente erzeugt, welche eine geringere Tiefe und/oder eine geringe laterale Ausdehnung aufweisen. Somit bedecken die zweiten Strukturelemente die Begrenzungsflächen der ersten Strukturelemente.

In einigen Ausführungsformen der Erfindung kann die Oberfläche der ersten Strukturelemente vollständig mit zweiten Strukturelementen bedeckt sein, insbesondere also auch senkrechte bzw. nahezu senkrechte Flächenbereiche. Durch diese Kombination einer Mikrostrukturierung und einer Nanostrukturierung können Kunststofffolien oder Kunststoffbauteile mit einer vergrößerten effektiven Oberfläche bereitgestellt werden. Die Oberflächenvergrößerung kann in einigen Ausführungsformen der Erfindung etwa einen Faktor 10 bis etwa einen Faktor 500 oberhalb der durch die makroskopischen Abmessungen des Kunststoffbauteils definierten Fläche liegen. In einigen Ausführungsformen der Erfindung können die erfindungsgemäß strukturierten Kunststofffolien für verbesserte Materialien zur Zellbesiedelung verwendet werden. In einigen Ausführungsformen der Erfindung kann die Biokompatibilität von Implantaten mit den erfindungsgemäß strukturierten Oberflächen verbessert sein. In wiederum anderen Ausführungsformen der Erfindung kann die Oberflächenstrukturierung zur verzögerten Wirkstofffreigabe pharmazeutischer Wirkstoffe verwendet werden. In diesen Fällen kann das erfindungsgemäße Bauteil ein Wirkstoffträger sein oder einen solchen enthalten.

Erfindungsgemäß werden die ersten Strukturelemente durch Laserstrukturierung erzeugt. Die Laserstrukturierung kann in einigen Ausführungsformen der Erfindung mit Kurzpulslasern durchgeführt werden, welche eine Pulsdauer von weniger als 100 Nanosekunden, weniger als 25 Nanosekunden oder weniger als 100 Femtosekunden aufweisen. Solche Kurzpulslaser führen durch nichtlineare optische und thermische Effekte zum Materialabtrag, welcher sich durch Pulsdauer, Pulsform, Wellenlänge, Leistung und Anzahl der Einzelpulse und Dauer der Pulsfolgezeiten mit großer Genauigkeit kontrollieren lässt. In anderen Ausführungsformen der Erfindung können erste Strukturelement auch photolithographisch oder durch spanende Bearbeitung erzeugt werden, beispielsweise durch Fräsen oder Schleifen.

In einem weiteren Verfahrensschritt werden zweite Strukturelemente erzeugt, welche eine geringere laterale Ausdehnung und/oder eine geringe Tiefe aufweisen als die ersten Strukturelemente. In einigen Ausführungsformen der Erfindung können die zweiten Strukturelemente in zumindest einer Raumrichtung mindestens einen Faktor 10 kleiner sein als die ersten Strukturelemente. In anderen Ausführungsformen der Erfindung können zweite Strukturelemente in zumindest einer Raumrichtung eine um einen Faktor 100 oder Faktor 1000 geringere Ausdehnung aufweisen.

Erfindungsgemäß werden die zweiten Strukturelemente durch anodische Oxidation erzeugt. Bei der anodischen Oxidation wird das Formwerkzeug als Anode geschaltet und in einen sauren Elektrolyten eingetaucht, so dass sich auf der Oberfläche der Anode eine Oxidschicht ausbildet.

In einigen Ausführungsformen der Erfindung kann eine polyprotische Säure als Elektrolyt Verwendung finden. In einigen Ausführungsformen der Erfindung kann die polyprotische Säure ausgewählt sein aus Schwefelsäure und/oder Oxalsäure und/oder Phosphorsäure. Die so erzeugte Oxidschicht ist nanoporös, mit senkrecht zur Oberfläche ausgerichteten Poren. Die Poren können hexagonal angeordnet sein. Dabei kann der Porenabstand, der Porendurchmesser und die Porentiefe durch die Prozessparameter der anodischen Oxidation beeinflusst werden. In einigen Ausführungsformen wird die Porengröße durch die angelegte Spannung, die Art des Elektrolyten, die Konzentration des Elektrolyten und die Temperatur des Elektrolyten bestimmt. Die Tiefe der Nanoporen kann durch die Zeit der anodischen Oxidation beeinflusst werden. Die durch die anodische Oxidation erzeugten Poren können in einigen Ausführungsformen der Erfindung um etwa einen Faktor 10, etwa einen Faktor 100 oder etwa einen Faktor 1000 kleiner sein als die laterale Ausdehnung der ersten Strukturelemente.

In einigen Ausführungsformen der Erfindung können die ersten Strukturelemente eine laterale Ausdehnung von etwa 0,5 µm und etwa 500 µm aufweisen. In anderen Ausführungsformen der Erfindung können die ersten Strukturelemente eine laterale Ausdehnung von etwa 10 µm bis etwa 100 µm aufweisen. In wiederum einer anderen Ausführungsform können die ersten Strukturelemente eine laterale Ausdehnung von etwa 15 µm bis etwa 25 µm aufweisen. Auf diese Weise können lebende Zellen in den Zwischenräumen zwischen benachbarten Strukturelementen eingelagert werden, so dass eine solchermaßen strukturierte Kunststofffolie bzw. ein solches Kunststoffbauteil als Zellkultursubstrat, als Wirkstoffträger oder als Implantatmaterial verwendbar ist.

In einigen Ausführungsformen der Erfindung können die ersten Strukturelemente von Höhe etwa 0,5 bis etwa 50 µm aufweisen. In anderen Ausführungsformen der Erfindung können die ersten Strukturelemente eine Höhe von etwa 1 µm bis etwa 10 µm aufweisen. In wiederum anderen Ausführungsformen der Erfindung können die ersten Strukturelemente eine Höhe von etwa 5 µm bis etwa 200 µm aufweisen.

In einigen Ausführungsformen der Erfindung kann das Formwerkzeug zumindest ein Metall oder zumindest eine Legierung enthalten oder daraus bestehen. Dieses Material kann sowohl durch spanende Bearbeitung als auch durch Lasermaterialbearbeitung einfach mit ersten Strukturelementen versehen werden. Aufgrund der guten elektrischen Leitfähigkeit eignet sich ein metallischer Werkstoff auch besonders gut zur anodischen Oxidation in einem sauren Elektrolyten.

In einigen Ausführungsformen der Erfindung kann das Formwerkzeug Aluminium und/oder Titan enthalten oder daraus bestehen. Beide Materialien lassen sich besonders einfach mittels anodischer Oxidation mit einer Oxidschicht versehen, welche Poren enthält und damit die erfindungsgemäßen zweiten Strukturelemente bereitstellt. Gleichzeitig ist die oxidierte Oberfläche dieser Metalle chemisch nahezu inert und hinreichend hart, so dass beim Formgebungsprozess nur geringer Verschleiß am Formwerkzeug auftritt.

In einigen Ausführungsformen der Erfindung kann die anodische Oxidation zur Erzeugung der zweiten Strukturelemente in einem mehrstufigen Verfahren durchgeführt werden. In einigen Ausführungsformen der Erfindung kann ein mehrstufiges Verfahren folgende Schritte enthalten: zumindest eine erste anodische Oxidation, das zumindest teilweise Entfernen einer Oxidschicht durch nasschemisches Ätzen und zumindest eine zweite anodische Oxidation. In einigen Ausführungsformen kann die erste anodische Oxidation zwischen 2 Stunden und etwa 6 Stunden andauern. Durch das teilweise Entfernen der Oxidschicht behält die Oberfläche des Formwerkzeugs den Abdruck der hexagonal angeordneten, halbkugelförmigen Porenböden. Diese regelmäßigen Vertiefungen in der Oberfläche des Formwerkzeuges dienen bei der zweiten anodischen Oxidation als Maske zur Porenbildung. In einigen Ausführungsformen der Erfindung kann die zweite anodische Oxidation unter den gleichen Bedingungen wie die erste anodische Oxidation stattfinden. Dieses Verfahren erlaubt eine hochgeordnete Struktur mit einer sehr engen Verteilung, d.h. die zweiten Strukturelemente sind mit nur geringen Zwischenräumen auf der Oberfläche der ersten Strukturelemente angeordnet.

In einigen Ausführungsformen der Erfindung können die Poren der Oxidschicht nach Abschluss der anodischen Oxidation durch nass- oder trockenchemisches Ätzen weiter geöffnet werden, um eine größere Porosität zu gewährleisten. Hierdurch entsteht eine dichtere Anordnung von zweiten Strukturelementen, welche eine weitere Vergrößerung der Oberfläche der Kunststofffolie bzw. des Bauteils ermöglichen. In einigen Ausführungsformen der Erfindung können die Nanoporen der zweiten Strukturelemente als Wirkstoffdepot für pharmazeutische Wirkstoffe oder Wirkstoffkombinationen verwendet werden, so dass bei Verwendung des strukturierten Bauteils als Zellkultursubstrat Wirkstoffe oder Nährstoffe unmittelbar an die angelagerten Zellen abgegeben werden können.

In einigen Ausführungsformen der Erfindung kann zwischen der Erzeugung der ersten Strukturelemente und der Erzeugung der zweiten Strukturelemente die Oberfläche optional durch Elektropolieren geglättet werden. In anderen Ausführungsformen der Erfindung kann alternativ oder zusätzlich zur Elektropolitur eine Plasmapolitur durchgeführt werden. Die Elektropolitur senkt die Mikrorauheit der metallischen Oberfläche des Formwerkzeugs. Aufgrund der Feldüberhöhung werden Rauheitsspitzen schneller abgetragen als Rauheitstäler, so dass sich eine spiegelnde Oberfläche bzw. spiegelnde Teilflächen auf dem Formwerkzeug ausbilden können. Kanten und Ecken werden ebenfalls aufgrund der Feldüberhöhung stärker abgetragen, was eine Feinstentgratung der ersten Strukturelemente bewirkt. Die ersten Strukturelemente selbst bleiben als vergleichsweise große Strukturen vom Elektropolieren unbeeinflusst, so dass die ersten Strukturelemente im Wesentlichen unverändert aus diesem Verfahrensschritt hervorgehen.

In einigen Ausführungsformen der Erfindung kann das Formwerkzeug nach Erzeugung der zweiten Strukturelemente getempert werden. In einigen Ausführungsformen der Erfindung kann das Tempern bei einer Temperatur von etwa 80°C bis etwa 1300°C erfolgen. In einigen Ausführungsformen der Erfindung kann das Tempern in einer oxidierenden Atmosphäre durchgeführt werden, um die durch anodische Oxidation entstandene Oxidschicht zu verstärken und/oder und gegebenfalls vorhandene Hydroxidverbindungen weiter zur oxidieren. In wiederum anderen Ausführungsformen der Erfindung kann das Tempern in einer Schutzgasatmosphäre durchgeführt werden, beispielsweise Stickstoff oder Argon, so dass die Oxidschicht nicht weiter aufgebaut wird.

Erfindungsgemäß wird beim Tempern γ-Aluminiumoxid in α-Aluminiumoxid umgesetzt. Hierdurch wird die Härte der Oxidschicht an der Oberfläche des Formwerkzeugs vergrößert, so dass die Standzeit des Formwerkzeuges beim Strukturieren von Kunststoffteilen erhöht sein kann.

In einigen Ausführungsformen der Erfindung kann nach dem Herstellen der zweiten Strukturelemente eine Antihaftbeschichtung auf der Oberfläche des Formwerkzeuges erzeugt werden. Die Antihaftbeschichtung kann eine geringere Oberflächenenergie aufweisen, so dass das Anhaften des zu strukturierenden Kunststoffmaterials am Formwerkzeug reduziert ist. In einigen Ausführungsformen der Erfindung kann die Antihaftbeschichtung mittels plasma enhanced chemical vapor deposition (PE-CVD) erzeugt werden. Das Plasma kann beispielsweise durch RF- oder Mikrowellenstrahlung erzeugt werden. Im Plasma werden gasförmige Precursoren angeregt und/oder dissoziiert, so dass diese auf der Oberfläche des Formwerkzeugs zur gewünschten Beschichtung polymerisieren können.

Die Precursoren zur Herstellung der Antihaftbeschichtung können siliziumorganische Monomere und/oder perfluorierte Kohlenwasserstoffe enthalten. In einigen Ausführungsformen der Erfindung können Kohlenwasserstoffe, wie beispielsweise Benzol oder Methan verwendet werden. In einigen Ausführungsformen der Erfindung kann Hexamethyldisilazan als Precursor eingesetzt werden. Daneben kann der Precursor Trägergase und/oder Dotierstoffe enthalten.

Die Antihaftbeschichtung kann in einigen Ausführungsformen eine Dicke von etwa 5 nm bis etwa 30 nm aufweisen. Eine solch dünne Antihaftbeschichtung kann sich formschlüssig an die Oberfläche der ersten und zweiten Strukturelemente anlegen, so dass insbesondere die Poren der zweiten Strukturelemente durch die Antihaftbeschichtung nicht egalisiert bzw. aufgefüllt werden. Gleichwohl ist eine solch dünne Beschichtung hinreichend, um ein Anhaften der erweichten Kunststoffmasse am Formwerkzeug zu verhindern oder zumindest zu reduzieren.

Das erfindungsgemäß hergestellte Formwerkzeug kann in einem Verfahren zum Heißprägen einer Kunststofffolie eingesetzt werden, bei welchem zumindest die Oberfläche der Kunststofffolie mit einem Farbstoff versehen wird. Durch Bestrahlung der Kunststofffolie mit elektromagnetischer Strahlung, deren Wellenlänge an eine Absorptionsbande des Farbstoffes angepasst ist, kann zumindest ein Teil der Kunststofffolie über die Verformungstemperatur erwärmt und nachfolgend mit einem Formwerkzeug umgeformt werden.

Es wird vorgeschlagen, dass der Farbstoff Nanopartikel enthält, welche zumindest ein Metall oder eine Legierung aus einer Mehrzahl von Metallen enthalten. Die Nanopartikel weisen gegenüber anderen, an sich bekannten Farbstoffen den Vorteil auf, dass eine geringe Massenbelegung der Kunststofffolie ausreichend ist, um das Material zu erwärmen. Dadurch können chemische Veränderungen an der Oberfläche durch die Beschichtung mit dem Farbstoff weitgehend vermieden werden.

Die Nanopartikel zeigen den Effekt der Plasmonenanregung. Dabei handelt es sich um die kollektive Schwingung der Leitungsbandelektronen eines Nanopartikels. Die spektrale Lage der Plasmonenresonanz wird vom Material der Nanopartikel, dem Material der Kunststofffolie bzw. des Kunststoffbauteils sowie der Partikelgröße und/oder der Partikelform und/oder der Lage der Partikel relativ zur Einstrahlrichtung der anregenden Strahlung bestimmt. Über die Elektron-Phonon-Kopplung werden die Nanopartikel erhitzt und geben diese Wärme an das Kunststoffmaterial ab. In einigen Ausführungsformen können die Nanopartikel Gold oder Silber enthalten oder daraus bestehen.

Die Verformungstemperatur kann in einigen Ausführungsformen ausgewählt sein aus der Glasübergangstemperatur oder der Schmelztemperatur oder einer Temperatur, welche um einen vorgebbaren Betrag niedriger gewählt ist als die Schmelztemperatur. In einigen Ausführungsformen kann die Temperatur 30 K oder 50 K oder 70 K unter der Schmelztemperatur liegen.

In einigen Ausführungsformen sind die Nanopartikel voneinander isoliert auf der Kunststofffolie angeordnet. Es wurde erkannt, dass eine einzige Monolage oder Bruchteile einer Monolage ausreichend sind, um zumindest einen oberflächennahen Bereich der Kunststofffolie über die Verformungstemperatur zu erwärmen, so dass diese nachfolgend in Kontakt mit dem Formwerkzeug umgeformt werden kann. Sofern das Formwerkzeug die vorstehend bereits beschriebene Oberflächenstruktur mit ersten Strukturelementen und zweiten Strukturelementen aufweist, so kann auch die Kunststofffolie bzw. das Kunststoffbauteil beim Heißprägen mit einer solchen Strukturierung versehen werden.

In einigen Ausführungsformen kann die elektromagnetische Strahlung aus dem sichtbaren Spektralbereich gewählt sein. Dies erlaubt eine besonders einfache optische Kontrolle des Erwärmungsprozesses. Darüber hinaus kann sichtbares Licht besonders einfach erzeugt werden, beispielsweise durch Halogenlampen oder Bogenlampen.

In einigen Ausführungsformen können die Nanopartikel durch ein PVD-Verfahren auf die Kunststofffolie aufgebracht werden. Das PVD-Verfahren kann ausgewählt sein aus Sputtern, Verdampfen oder ionengestützter Metallabscheidung. Diese Verfahren erlauben eine genaue Kontrolle der Massenbelegung der Oberfläche der Kunststofffolie. Darüber hinaus wird durch die Abscheidung im Vakuum die Koagulation und Koaleszenz der Nanopartikel vermieden, so dass sich keine Agglomerate auf der Oberfläche der Kunststofffolie bilden. Solche Agglomerate weisen ein abweichendes Absorptionsverhalten auf, so dass die gleichmäßige Erwärmung nicht sichergestellt werden kann.

In einigen Ausführungsformen des Verfahrens kann das Verhältnis der Größe eines Nanopartikels zur Wellenlänge der zur Erwärmung verwendeten elektromagnetischen Strahlung etwa 0,1 bis etwa 1 betragen. Somit sind die Nanopartikel in der Regel kleiner als die Wellenlänge der zur Erwärmung verwendete elektromagnetischen Strahlung. Hierdurch wird eine effiziente Anregung der Oberflächenplasmonen auf den Nanopartikeln sichergestellt.

In einigen Ausführungsformen kann die optische Transmission der Kunststofffolie während der Erwärmung und/oder Umformung gemessen werden. Es hat sich gezeigt, dass durch die Erwärmung der Kunststofffolie durch Absorption elektromagnetischer Strahlung an den Nanopartikeln eine Änderung der Größe und/oder Form der Nanopartikel durch Koaleszenz und Rekristallisation auftritt und/oder Nanopartikel, welche eine ellipsoidale Form haben, sich durch thermische Bewegungen der Polymerketten umorientieren. Hierdurch kommt es zur Veränderung der Größe der Nanopartikel und/oder der Form der Nanopartikel. Dies führt zu einer Verschiebung der spektralen Lage der Plasmonenresonanz und damit zu einer Verschiebung des Absorptionsmaximums. Somit kann in einigen Ausführungsformen die Zufuhr von Heizenergie bei Erreichen einer hinreichenden Erwärmung der Kunststoffoberfläche automatisch gedrosselt werden. Gleichzeitig kann der Zeitpunkt ausreichender Erwärmung durch Erfassen des Absorptionsmaximums erkannt werden, so dass eine einfache Prozesskontrolle des Heißprägeverfahrens ermöglicht wird.

In einigen Ausführungsformen kann es zu einer visuell sichtbaren farblichen Veränderung der Folie bei Erwärmung kommen. Beispielsweise kann die Kunststofffolie eine transluzente Färbung verlieren und durch die Erwärmung optisch transparent werden, weil die Nanopartikel nicht mehr alle in einer Ebene angeordnet sind. Somit können heißgeprägte Folien einfach von nicht heißgeprägten Folien unterschieden werden, so dass ein versehentliches Vertauschen von Halbzeugen und Fertigwaren vermieden werden kann. Weiterhin kann das Verfahren trotz des Farbstoffes auch für Produkte eingesetzt werden, deren optische Eigenschaften für die Funktion wesentlich sind. Solche Produkte konnten mit bisher verwendeten Farbstoffen aufgrund der dauerhaft im Endprodukt verbleibenden Einfärbung nicht hergestellt werden.

In einigen Ausführungsformen kann die Kunststofffolie zumindest eine erste Schicht und zumindest eine zweite Schicht enthalten, wobei die erste Schicht ein Polymer höherer Dichte und/oder höherer Verformungstemperatur enthält und die zweite Schicht ein Polymer niedrigerer Dichte und/oder niedrigerer Verformungstemperatur enthält. In einigen Ausführungsformen kann die erste Schicht ultrahigh molecular weight polyethylen (UHMW-PE) und/oder Polyetheretherketon (PEEK) und/oder Polyethylenterephthalat (PET) und/oder Polyamid (PA) enthalten. In einigen Ausführungsformen kann die zweite Schicht Polyethylen (PE) und/oder high density polyethylen (HD-PE) und/oder low density polyethylen (LD-PE) und/oder Polystyrol (PS) und/oder Polypropylen (PP) und/oder zumindest ein Fluorpolymer enthalten. Die erste Schicht und die zweite Schicht können durch Laminieren bzw. Verschweißen miteinander verbunden sein. Hierdurch können auch Kunststofffolien mit einer strukturierten Oberfläche versehen werden, welche im Wesentlichen aus einem Material bestehen, welches einer Umformung durch Heißprägen nicht zugänglich ist. Hierdurch kann ein Material höherer Reißfestigkeit oder höherer thermischer Beständigkeit bereitgestellt werden, welches gleichwohl mit der Oberflächenstruktur versehen ist.

In einigen Ausführungsformen können die Nanopartikel Gold und/oder Silber enthalten. Diese Nanopartikel weisen eine besonders gute Lichtabsorption und damit eine effiziente Erwärmung auf. Nanopartikel aus Silber können aufgrund Ihrer keimtötenden bzw. keiminaktivierenden Wirkung auch für mikrobiologisch sensible Anwendungen eingesetzt werden. Das Auftreten von unerwünschten Infektionen kann dadurch reduziert sein.

In einigen Ausführungsformen kann eine Kunststofffolie zumindest eine erste Schicht und zumindest zwei zweite Schichten enthalten, wobei die erste Schicht ein Polymer größerer Härte und/oder mit höherer Verformungstemperatur enthält und die zweiten Schichten ein Polymer geringerer Härte und/oder mit geringerer Verformungstemperatur enthalten, wobei die zweiten Schichten beidseitig der ersten Schicht angeordnet sind. Auf diese Weise kann eine Folie große mechanische Belastbarkeit aufweisen und gleichzeitig einfach auf beiden Seiten mit der strukturierten Oberfläche versehen werden.

Nachfolgend soll die Erfindung anhand von Figuren ohne Beschränkung des allgemeinen Erfindungsgedankens näher erläutert werden. Dabei zeigt
Fig. 1 einen Teil eines Formwerkzeugs ohne Oberflächenstrukturierung.
Fig. 2 zeigt einen Teil eines Formwerkzeugs mit ersten Strukturelementen.
Fig. 3 zeigt einen Teil eines Formwerkzeugs nach dem Elektropolieren.
Fig. 4 zeigt einen Teil eines Formwerkzeugs nach dem Herstellen zweiter Strukturelemente.
Fig. 5 zeigt einen Teil eines Formwerkzeugs nach der Stabilisierung der zweiten Strukturelemente.
Fig. 6 zeigt einen Teil eines Formwerkzeugs nach dem Aufbringen einer Antihaftbeschichtung.
Fig. 7 zeigt beispielhaft die Anwendung des Formwerkzeugs in einem ersten Verfahrensschritt eines Spritzgussverfahrens.
Fig. 8 zeigt beispielhaft die Anwendung des Formwerkzeugs in einem zweiten Verfahrensschritt eines Spritzgussverfahrens.
Fig. 9 zeigt beispielhaft ein Kunststoffbauteil bzw. eine Kunststofffolie.
Fig. 10 zeigt beispielhaft eine Kunststofffolie bzw. ein Kunststoffbauteil.
Fig. 11 zeigt eine Vorrichtung zum Heißprägen.
Fig. 12 zeigt den ersten Verfahrensschritt eines Heißprägeverfahrens in einer ersten Ausführungsform.
Fig. 13 zeigt den zweiten Verfahrensschritt eines Heißprägeverfahrens in einer ersten Ausführungsform.
Fig. 14 zeigt den dritten Verfahrensschritt eines Heißprägeverfahrens in einer ersten Ausführungsform.
Fig. 15 zeigt den ersten Verfahrensschritt eines Heißprägeverfahrens in einer zweiten Ausführungsform.
Fig. 16 zeigt einen zweiten Verfahrensschritt des Heißprägeverfahrens in einer zweiten Ausführungsform.
Fig. 17 zeigt den dritten Verfahrensschritt eines Heißprägeverfahrens in einer zweiten Ausführungsform.

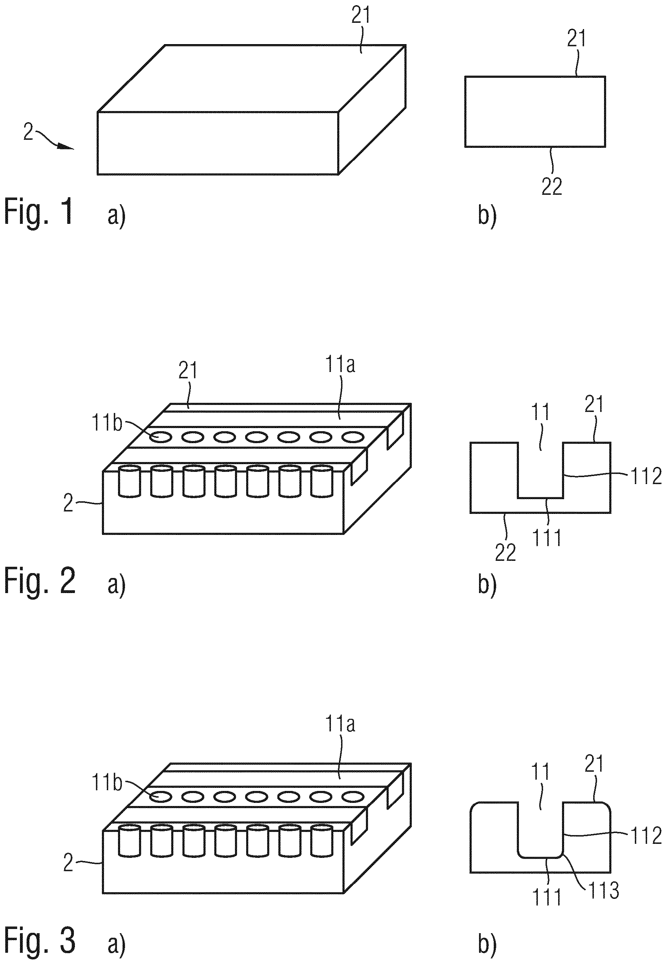

Anhand der Figuren 1 bis 6 wird das erfindungsgemäße Verfahren zur Herstellung eines Formwerkzeuges erläutert. Dabei zeigen die Fig. 1a, 2a, 3a, 4a, 5a und 6a jeweils eine axonometrische Darstellung. In Fig. 1b, 2b, 3b, 4b, 5b und 6b ist ein Querschnitt durch das Formwerkzeug gezeigt.

Im ersten Verfahrensschritt wird das Basissubstrat des Formwerkzeuges 2 bereitgestellt. Das Basissubstrat kann ein Metall oder eine Legierung enthalten. In einigen Ausführungsformen der Erfindung kann das Basissubstrat Aluminium oder Titan enthalten. Diese Materialien sind einerseits einfach bearbeitbar und bilden eine stabile Oxidschicht an ihrer Oberfläche aus, welche aufgrund Ihrer Härte einen geringen abrasiven Verschleiß des Formwerkzeugs sicherstellen und chemisch weitgehend inert sind.

Im dargestellten Ausführungsbeispiel wird ein in etwa rechteckiges Ausgangssubstrat mit einer ersten Seite 21 und einer gegenüberliegenden zweiten Seite 22 verwendet. In anderen Ausführungsformen der Erfindung kann das Substrat eine andere Grundform besitzen. Insbesondere kann für kontinuierliche Heißprägeprozesse ein in etwa zylinderförmiges Formwerkzeug eingesetzt werden.

Fig. 2 zeigt das Formwerkzeug nach Durchführung eines ersten Verfahrensschrittes, in welchem erste Strukturelemente 11A und 11B erzeugt werden. Die ersten Strukturelemente können beispielsweise durch Laserstrukturierung erzeugt werden. Hierbei bewirkt die Laserstrahlung einen Materialabtrag, so dass beispielsweise ein Graben 11A oder eine Mehrzahl von Bohrungen 11B auf der ersten Seite 21 des Formwerkzeuges 2 erzeugt werden können. In anderen Ausführungsformen der Erfindung können die ersten Strukturelemente eine andere Form aufweisen. Die Erfindung wird jedoch in den nachfolgenden Figuren beispielhaft anhand eines Grabens 11A als erstes Strukturelement 11 näher erläutert. Die Form der ersten Strukturelemente 11 kann nach dem gewünschten Verwendungszweck der strukturierten Kunststoffbauteile gewählt sein, so dass sich beispielsweise Zellen zwischen den ersten Strukturelementen 11 anlagern können.

Die ersten Strukturelemente können eine laterale Auflösung von etwa 0,5pm bis etwa 500µm oder von etwa 10pm bis etwa 100µm aufweisen. Wie in Fig. 2B ersichtlich, weist ein Graben 11 als beispielhaftes erstes Strukturelement zwei gegenüberliegende, in etwa senkrecht zur ersten Seite 21 verlaufende und parallel zueinander angeordneten Begrenzungsflächen 112 auf. Den Grund des Strukturelements 11 bildet die Bodenfläche 111, welche in etwa parallel zur ersten Seite 21 und zur zweiten Seite 22 verläuft. Nach der Herstellung der ersten Strukturelemente können die Begrenzungskanten zwischen den Flächen 112 und der ersten Seite 21 sowie zwischen den Flächen 112 und der Fläche 111 vergleichsweise scharfkantig sein oder einen Grat aufweisen.

Fig. 3 zeigt das Formwerkzeug nach einer optionalen Elektropolitur. Bei der Elektropolitur wird das Formwerkzeug 2 in einem sauren Elektrolyt mit einer elektrischen Gleich- oder Wechselspannung beaufschlagt. Vor der Elektropolitur kann ein optionaler Reinigungsschritt erfolgen, um eine fettfreie Oberfläche des Formwerkzeuges 2 bereitzustellen. Dies kann eine gleichmäßigere Wirkung der Elektropolitur bewirken.

Da an Bauteilkanten oder Spitzen eine elektrische Feldüberhöhung auftritt, ist die Wirkung der Elektropolitur an Kanten und Graten stärker als an ebenen Flächen. Hierdurch wird die Oberfläche der ersten Strukturelemente 11 und/oder der ersten Seite 21 geglättet, da vorstehende Teilbereiche der Begrenzungsflächen einen stärkeren Abtrag durch die Elektropolitur unterliegen. Weiterhin können Kanten entgratet oder verrundet werden, wie beispielhaft am Übergang 113 zwischen den Begrenzungsflächen 111 und 112 des ersten Strukturelements 11 gezeigt ist. Eine solche verrundete Form kann beim Abformen des Formwerkzeugs vorteilhaft sein, da die weiche Kunststoffmasse leichter in solche verrundeten Strukturen eindringen kann, um diese vollständig auszufüllen.

Die Zeitdauer der Elektropolitur und die Abtragrate werden so gewählt, dass unerwünschte Grate und Rauhigkeiten abgetragen werden, jedoch die ersten Strukturelemente 11 in der gewünschten Form erhalten bleiben.

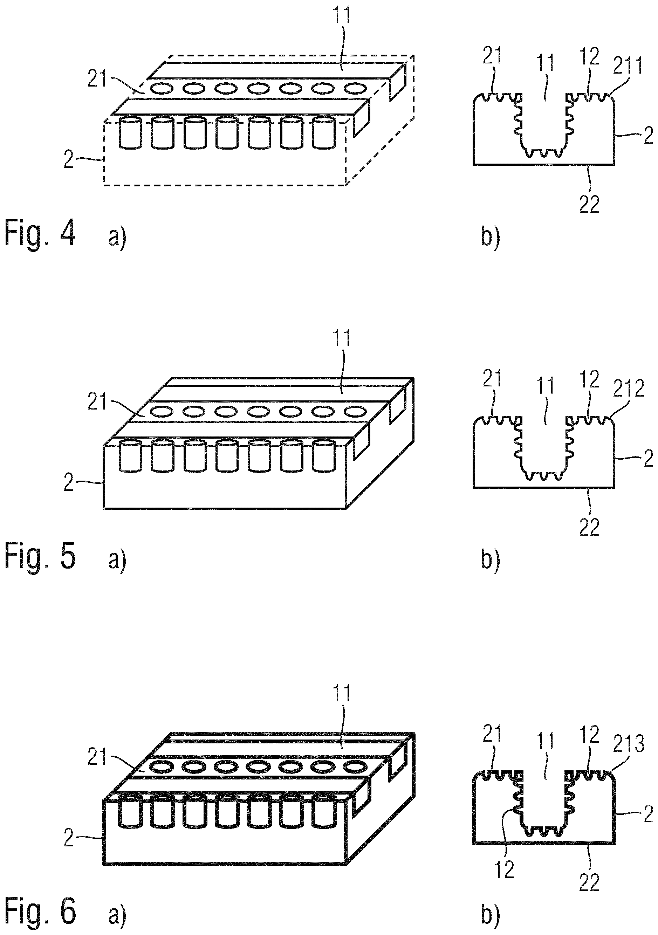

Fig. 4 zeigt das Formwerkzeug 2 nach der Herstellung der zweiten Strukturelemente 12. Im dargestellten Ausführungsbeispiel umfassen die zweiten Strukturelemente 12 Poren, welche die gesamte erste Seite 21 sowie sämtliche Begrenzungsflächen der ersten Strukturelemente 11 bedecken. Die Poren 21 können in einer hexagonal dichten Anordnung auf der ersten Seite 21 des Formwerkzeugs 2 angeordnet sein.

Im dargestellten Ausführungsbeispiel werden die Poren 21 durch anodische Oxidation des Formwerkzeugs 2 erzeugt. Die anodische Oxidation kann in einigen Ausführungsformen der Erfindung in einer polyprotischen Säure erfolgen, wodurch sich eine Oxidschicht auf der ersten Seite 21 und den ersten Strukturelementen 11 bildet. Die Oxidschicht weist eine intrinsische Porosität auf, welche fakultativ durch selektives Ätzen weiter geöffnet werden kann, um die dargestellten offenen zweiten Strukturelemente 12 bereitzustellen.

Sofern für das Formwerkzeug 2 Aluminium oder eine Aluminiumlegierung gewählt wurde, bildet sich während der anodischen Oxidation eine Schicht 211, welche Aluminiumoxid enthält. Hierdurch wird das Formwerkzeug 2 vor weiterem korrosivem Angriff geschützt. Aufgrund der höheren Härte des Oxids gegenüber dem reinen Metall kann darüber hinaus der abrasive Verschleiß beim Abformen verringert werden. In einigen Ausführungsformen der Erfindung können die zweiten Strukturelemente 12 eine laterale Ausdehnung und/oder eine Tiefe aufweisen, welche zumindest einen Faktor 10 kleiner ist als die laterale Ausdehnung und/oder die Tiefe der ersten Strukturelemente 11. Hierdurch kann die Oberfläche des Formwerkzeugs und damit die Oberfläche des abgeformten Bauteils vergrößert werden, beispielsweise um einen Wirkstoffträger für pharmazeutische Wirkstoffe oder ein Zellkultursubstrat bereitzustellen.

Die weiteren, in den Figuren 5 und 6 dargestellten optionalen weiteren Verfahrensschritte dienen der weiteren Verbesserung der Standfestigkeit des Formwerkzeugs und/oder der Verbesserung der Produktqualität des mit dem Formwerkzeug 2 hergestellten Kunststoffbauteils.

Im Verfahrensschritt 5 kann das Formwerkzeug getempert werden. In einigen Ausführungsformen der Erfindung kann dies bei einer Temperatur zwischen etwa 800° und etwa 1300° erfolgen. Optional kann eine Schutzgasatmosphäre anliegen, um eine weitere Oxidation der ersten Seite 21 des Formwerkzeugs 2 zu verhindern. Die Temperaturbehandlung des Formwerkzeugs 2 kann bewirken, dass γ-Aluminiumoxid in α-Aluminiumoxid umgewandelt wird. Das α-Aluminiumoxid 212 kann eine größere mechanische Stabilität und/oder eine erhöhte Beständigkeit gegen Lösemittel, Säuren und/oder Laugen aufweisen.

Fig. 6 zeigt das Formwerkzeug nach einem weiteren optionalen Verfahrensschritt, nämlich der Abscheidung einer Antihaftbeschichtung 213. Die Antihaftbeschichtung 213 kann eine geringere Oberflächenenergie aufweisen, so dass das Anhaften von erwärmter und damit fließfähiger Kunststoffmasse reduziert und dadurch das Abformen des fertigen Kunststoffbauteils erleichtert ist.

In einigen Ausführungsformen der Erfindung kann die Antihaftbeschichtung 213 ein Plasmapolymer enthalten oder daraus bestehen, welches durch Abscheidung gasförmiger Precursoren aus der Gasphase erhältlich ist. Die Antihaftbeschichtung 213 kann eine siliziumorganische oder fluororganische Verbindung enthalten oder daraus bestehen. Solche Beschichtungen sind beispielsweise aus der Polymerisation von Hexamethyldisilazan oder perflorierten Kohlenwasserstoffen erhältlich.

Die Antihaftbeschichtung kann eine mittlere Schichtdicke von weniger als 10 nm aufweisen, so dass diese sowohl die ersten Strukturelemente 11 als auch die zweiten Strukturelemente 12 vollständig bedeckt, ohne jedoch die Strukturelemente vollständig aufzufüllen und damit das Abformen insbesondere der zweiten Strukturelemente 12 zu verhindern.

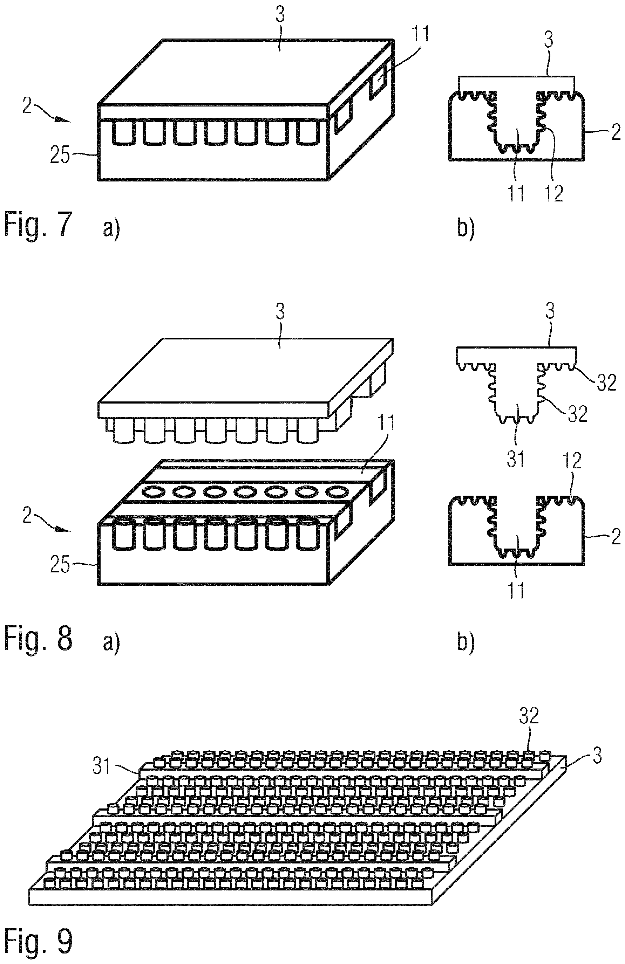

Anhand der Figuren 7 und 8 wird ein Spitzgussverfahren unter Verwendung des erfindungsgemäß hergestellten Formwerkzeuges erläutert. Dabei zeigt Fig. 7a und Fig. 8a eine axonometrische Darstellung des Formwerkzeuges und des Kunststoffbauteils. Fig. 7b und 8b zeigen jeweils einen Querschnitt durch das Formwerkzeug 2 und das damit hergestellte Kunststoffbauteil 3.

Das anhand des vorstehend beschriebenen Verfahrens hergestellte Formwerkzeug 2 kann in eine an sich bekannte Spritzgussmaschine eingesetzt werden. Hierdurch können Kunststoffbauteile mit einer Gesamtmasse von weniger 1 mg bis hin zu mehr als 10 kg mit Zykluszeiten von wenigen Sekunden bis zu mehreren Minuten hergestellt werden. Hierzu wird das Kunststoffgranulat in an sich bekannter Weise durch eine rotierende und beheizte Schnecke aufgeschmolzen und unter Druck in die Spritzgussform gefördert.

Fig. 7 zeigt, wie das Kunststoffbauteil bzw. das noch oberhalb der Verformungstemperatur erwärmte Kunststoffmaterial die Hohlräume des Formwerkzeuges 2 ausfüllt. Hierbei dringt das Kunststoffmaterial sowohl in die ersten Strukturelemente 11 als auch in die zweiten Strukturelemente 12 ein. Der Füllungsgrad kann über die Viskosität des verflüssigten Rohmaterials und den Prozessdruck beeinflusst werden. Eine geringe Schrumpfung des Kunststoffmaterials beim Abkühlen kann das Entformen des Bauteils 3 aus dem Formwerkzeug 2 erleichtern.

Fig. 8 zeigt den Vorgang des Entformens. Hierbei wird das Kunststoffbauteil 3 vom Formwerkzeug 2 getrennt. Insbesondere in Fig. 8b ist erkennbar, dass das Kunststoffbauteil 3 ein erstes Strukturelement 31 aufweist, dessen Formgebung durch erste Strukturelemente 11 des Formwerkzeugs 2 erfolgt ist. Das erste Strukturelement 31 ist von einer Mehrzahl zweiter Strukturelemente 32 bedeckt, welche durch die zweiten Strukturelemente 12 des Formwerkzeugs 2 geformt wurden. Somit ist das Kunststoffbauteil bzw. die Kunststofffolie 3 sowohl Mikro- als auch Nanostrukturiert.

Fig. 9 zeigt ein erstes Ausführungsbeispiel eines Kunststoffbauteils 3. Das Kunststoffbauteil 3 hat im Wesentlichen die Grundform einer planparallelen Platte, welche an einer Oberfläche erste Strukturelemente 31 in Form von Rippen trägt, welche sich über die gesamte Längserstreckung des Kunststoffbauteils 3 erstrecken. Die gesamte Oberfläche ist mit zweiten Strukturelementen 32 versehen, welche eine in etwa zylinderförmige Grundform aufweist. Die zweiten Strukturelemente 32 bedecken auch die ersten Strukturelemente 31, so dass das Kunststoffbauteil 3 sowohl mikro- als auch nanostrukturiert ist.

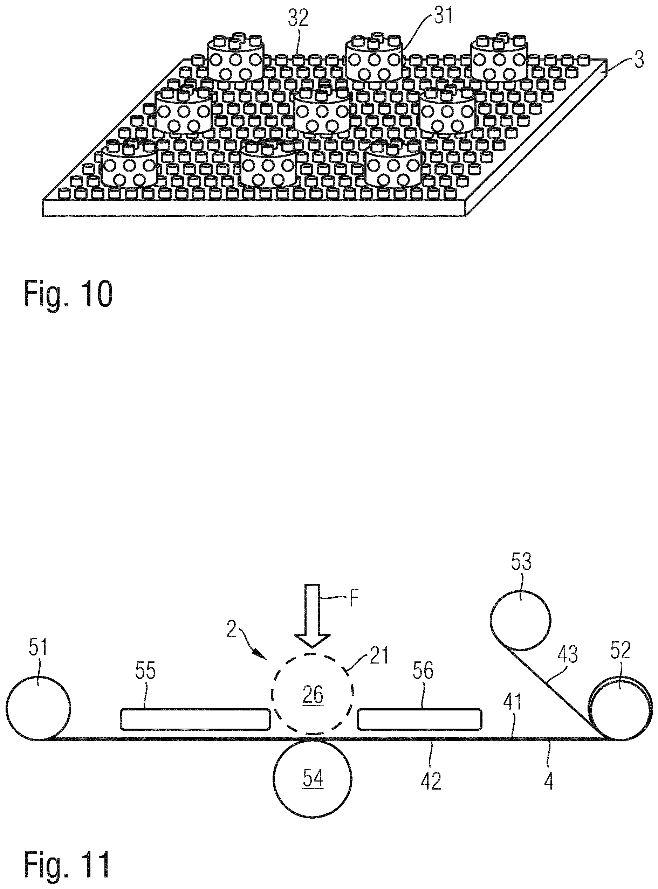

Fig. 10 zeigt ein zweites Ausführungsbeispiel eines Kunststoffbauteils 3. Auch das Kunststoffbauteil 3 gemäß der zweiten Ausführungsform weist erste Strukturelemente 31 auf. Im dargestellten Ausführungsbeispiel sind die ersten Strukturelemente 31 in etwa zylinderförmig und in einem gleichmäßigen Raster auch der Oberfläche des Kunststoffbauteils 3 angeordnet.

Die gesamte Oberfläche des Kunststoffbauteils 3 ist von zweiten Strukturelementen 32 bedeckt, welche ebenfalls eine etwa zylinderförmige Grundform aufweisen. Die zweiten Strukturelemente 32 sind jedoch wesentlich kleiner, d.h. mindestens einen Faktor 10. Diese bedecken auch die senkrechten Flächenbereiche der ersten Strukturelemente 31 und sorgen so für eine effiziente Vergrößerung der Oberfläche des Kunststoffbauteils bzw. der Kunststofffolie 3.

Fig. 11 erläutert eine Vorrichtung zur Durchführung eines Heißprägeprozesses, mit welchem eine Folienbahn 4 kontinuierlich mit einer Oberflächenstrukturierung versehen werden kann, beispielsweise mit der in Fig. 9 oder Fig. 10 gezeigten Struktur. Hierzu wird die unstrukturierte Folienbahn 4 von einer ersten Vorratstrommel 51 abgewickelt. Daraufhin durchläuft die Folienbahn 4 ein Heizelement 55, welches zumindest die erste Seite 41 erwärmt. Der Wärmeeintrag kann dabei so gesteuert werden, dass die zweite Seite 42 nicht über die Verformungstemperatur erwärmt wird, um die mechanische Stabilität der Folienbahn 4 während des Heißprägeverfahrens sicherzustellen. Die erste Seite 41 wird jedoch oberhalb der Verformungstemperatur erwärmt, um das plastische Verformen durch das Formwerkzeug 2 zu ermöglichen.

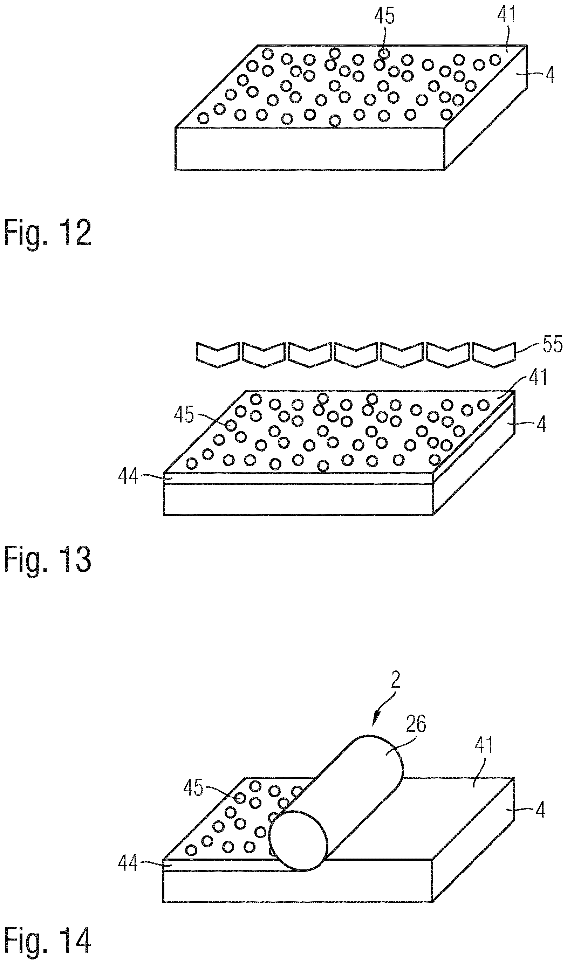

Hierzu kann die Heizvorrichtung 55 elektromagnetische Strahlung aussenden, beispielsweise im infraroten Spektralbereich, im sichtbaren Spektralbereich oder im ultravioletten Spektralbereich. Die Folienbahn 4 kann mit einem Farbstoff versehen sein, wie nachfolgend anhand der Fig. 12 bis 14 erläutert. Hierdurch wird eine selektive Erwärmung der ersten Seite 41 ermöglicht, so dass auch dünne Folien 4 mit einer Dicke von etwa 10 µm bis etwa 125 µm im Heißprägeverfahren strukturiert werden können, ohne durch zu großen Wärmeeintrag Schaden zu nehmen.

Die von der Heizvorrichtung 55 erwärmte Folienbahn durchläuft das Formwerkzeug 2, welches die Form einer zylinderförmigen Walze 26 aufweist. Die Mantelfläche 21 der zylinderförmigen Walze 26 ist mit der Strukturierung versehen, welche sowohl erste Strukturelemente als auch zweite Strukturelemente aufweist, wobei die zweiten Strukturelemente kleiner sind als die ersten Strukturelemente. Fakultativ kann auch die zylinderförmige Walze 26 mit einer Oxidschicht und/oder einer Antihaftschicht versehen sein, wie vorstehend anhand der Figuren 5 und 6 erläutert, um das Anhaften der Kunststoffmasse zu reduzieren oder die Standzeit des Formwerkzeuges zu erhöhen.

Um die für die Formgebung erforderlichen Prägekräfte aufzubringen, kann gegenüber dem Formwerkzeug 2 eine Gegenwalze 54 angeordnet sein. Die Gegenwalze 54 kann eine glatte Oberfläche aufweisen, um eine Beschädigung bzw. eine unerwünschte Umformung der zweiten Seite 42 der Folienbahn 4 zu vermeiden oder optional die dieselbe oder auch eine andere nach dem erfindungsgemäßen Verfahren strukturierte Oberfläche aufweisen, um die Strukturierung beidseitig durchführen zu können.

Sofern die Folienbahn 4 in Kontakt mit dem Formwerkzeug 2 bereits abkühlt, kann die dadurch verursachte Schrumpfung das Ausformen der Folienbahn 4 aus dem Formwerkzeug 2 erleichtern.

Nach dem Heißprägeprozess mit dem Formwerkzeug 2 kann die Folienbahn 4 optional durch eine Kühlvorrichtung 56 laufen, um ein rasches Erstarren unterhalb der Verformungstemperatur und damit eine mechanische Stabilisierung der Mikrostrukturierung zu ermöglichen.

Nach der Mikrostrukturierung und der Abkühlung kann die Kunststofffolie 4 auf eine zweite Vorratstrommel 52 aufgerollt werden. Um eine Beschädigung der Strukturierung zu vermeiden, kann eine optionale Schutzfolie 43 aufgebracht werden, welche von einer dritten Vorratstrommel 53 abgerollt und zusammen mit der Kunststofffolie 4 auf die zweite Vorratstrommel 52 aufgerollt wird.

Anhand der Figuren 12, 13 und 14 wird eine Verfahrensführung erläutert, welche das selektive Erwärmen der ersten Seite 41 einer Kunststofffolie 4 erlaubt. Hierzu wird die Kunststofffolie 4 mit Nanopartikeln 45 beschichtet. Die Nanopartikel 45 weisen eine Größe auf, welche geringer ist als die Wellenlänge der zur Erwärmung verwendeten elektromagnetischen Strahlung. Hierdurch können Plasmonenresonanzen auf der Oberfläche der Nanopartikel 45 angeregt werden, welche zur Erwärmung der Nanopartikel und nachfolgend zur Erwärmung der Kunststofffolie 4 führen.

Da die Nanopartikel 45 nur auf der ersten Seite 41 der Kunststofffolie 4 aufgebracht sind, dringt die Wärme ausgehend von der ersten Seite 41 in die Tiefe der Kunststofffolie 4 ein, wie anhand von Fig. 13 schematisch dargestellt. Hierdurch bildet sich eine an die ersten Seite 41 angrenzende Schicht 44 aus, welche aufgrund der von der Heizvorrichtung 55 ausgesandten elektromagnetischen Strahlung über die Verformungstemperatur erwärmt wird. Damit kann die erste Seite 41 plastisch verformt und mit der Mikro- und Nanostrukturierung versehen werden. Gleichzeitig erwärmt sich jedoch die gegenüberliegende Seite der Kunststofffolie und/oder tiefere Schichten im Volumen der Folie nicht über die Verformungstemperatur, so dass deren mechanischen Stabilität während des Prägeprozesses erhalten bleibt und ein sicheres Abziehen der Kunststofffolie gewährleistet ist.

Es wurde erkannt, dass das Aufbringen der Nanopartikel 45 mittels eines PVD-Verfahrens dazu führt, dass einzelne Nanopartikel 45 beabstandet zueinander auf der Oberfläche 41 angeordnet sind. Hierdurch wird das Auftreten von Agglomeraten vermieden, so dass die Plasmonenresonanz eine Lichtabsorption in einem Teil des elektromagnetischen Spektrums ermöglicht. Licht anderer Wellenlänge kann die Kunststofffolie 4 durchdringen, ohne eine wesentliche Menge thermischer Energie in der Kunststofffolie 4 zu deponieren, so dass die Erwärmung auf die an die erste Seite 41 angrenzende Schicht 44 begrenzt bleibt.

Wie Fig. 14 zeigt, führt die Einwirkung des Formwerkzeugs 2 bzw. der Prägewalze 26 zu einer Änderung der Verteilung der Nanopartikel 45. Die Partikel können Agglomerate bilden und/oder in tiefere Schichten der Kunststofffolie 4 diffundieren, so dass sich durch die Umlagerung der Polymerketten Partikel mit anderer Orientierung in tieferen Schichten der Kunststofffolie befinden, so dass die Plasmaonresonanz sich spektral verschiebt oder auch ganz verschwindet. Hierdurch kann die Kunststofffolie 4 nach dem Heißprägeprozess transparent erscheinen, so dass einerseits eine optische Qualitätskontrolle durch Messung des Absorptionsspektrums ermöglicht wird und das Verfahren trotz des Aufbringens eines Farbstoffes auch für Kunststofffolien 4 geeignet ist, welche in der Endanwendung farblos erscheinen sollen.

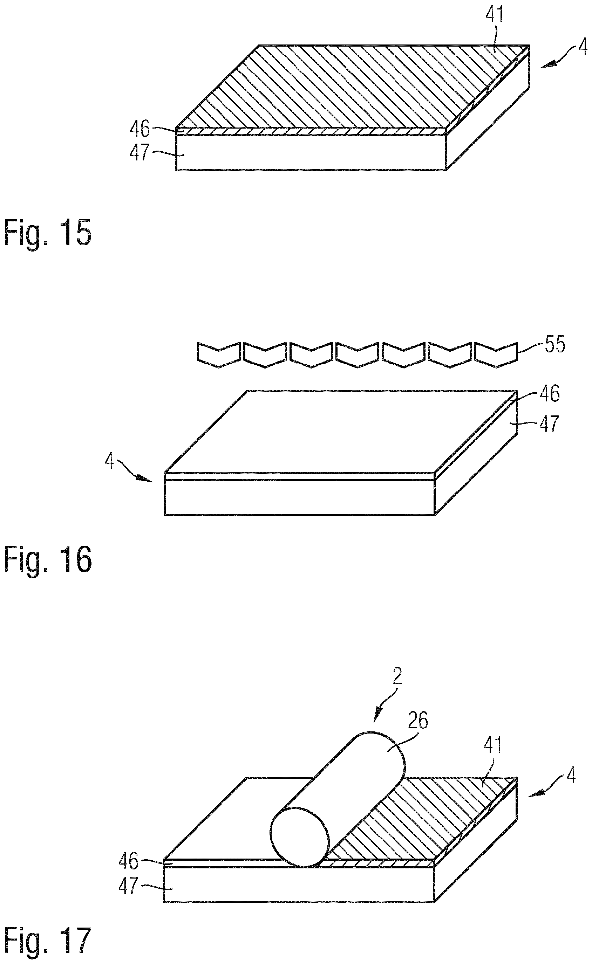

Anhand der Figuren 15, 16 und 17 wird das Heißprägen einer Kunststofffolie 4 erläutert, welche eine erste Schicht 47 und eine zweite Schicht 46 enthält. Die erste Schicht 47 kann ein Polymer enthalten, welches eine größere Härte und/oder eine höhere Verformungstemperatur aufweist als die zweite Schicht. Die erste Schicht 47 und die zweite Schicht 46 können beispielsweise durch vollflächiges Laminieren bzw. Verschweißen miteinander verbunden sein. Auf diese Weise können Kunststofffolien 4 mit der Strukturierung versehen werden, auch wenn diese überwiegend aus einem Material hoher Härte oder hoher Verformungstemperatur bestehen, welches einem bekannten Heißprägeverfahren nicht zugänglich ist. Beispielsweise kann die erste Schicht 47 aus Polyetheretherketon bestehen.

Wie Fig. 16 zeigt, kann die Heizvorrichtung 55 eine elektromagnetische Strahlung aussenden, welche selektiv vom Material der zweiten Schicht 46 absorbiert wird. Hierdurch kann der Wärmeeintrag in die Kunststofffolie 4 auf eine Schicht angrenzend an die erste Seite 41 beschränkt werden, wie vorstehend beschrieben. Somit ist die mechanische Stabilität der Kunststofffolie 4 während des Heißprägeprozesses sichergestellt.

Wie Fig. 17 zeigt, wird die zweite Schicht 46 der Kunststofffolie 4 nach dem durch das Formwerkzeug 2 initiierten Umformprozess abgekühlt und nachfolgend auf eine Vorratsrolle aufgewickelt, wie anhand von Fig. 11 bereits beschrieben wurde. Da während des gesamten Heißprägeprozesses die erste Schicht 47 nicht über die Verformungstemperatur erwärmt wird und somit ihre mechanische Stabilität behält, können konstante Folienabzugskräfte sichergestellt werden, wodurch sich die Produktqualität erhöht.

Die vorgeschlagenen Kunststoffbauteile 3 bzw. Kunststofffolien 4 können als Zellkultursubstrat eingesetzt werden, welches eine zu physiologischen Oberflächen ähnliche Oberflächenstruktur aufweist. Die vergleichsweise großen ersten Strukturelemente schaffen Oberflächen, welche mit natürlichem Gewebe vergleichbar sind und das Wachstum bzw. die Anlagerung von Zellen durch Begrenzung von natürlichen Bindungsstellen initiieren. Die vergleichsweise kleinen zweiten Strukturelemente 12 können der Aufnahme funktioneller Gruppen dienen, beispielsweise Proteine. Alternativ oder zusätzlich können die zweiten Strukturelemente als Reservoir für pharmazeutische Wirkstoffe und/oder Nährstoffe dienen, welche das Zellwachstum positiv beeinflussen können.

In anderen Ausführungsformen kann ein Kunststoffbauteil 3 als Wirkstoffträger für pharmazeutische Wirkstoffe dienen. Hierdurch kann ein Arzneistoff unter kontrollierten Bedingungen an seinen Wirkort in einem menschlichen oder tierischen Körper transportiert und dort kontrolliert in einer gewünschten Zeitspanne freigesetzt werden. Hierdurch kann die eingesetzte Wirkstoffmenge reduziert werden.

Schließlich können Kunststoffbauteile 3 mit der Oberflächenstruktur als Implantatmaterial verwendet werden. Die Kunststoffbauteile können einen lasttragenden Kern aufweisen, welcher eine zuverlässige Osteosynthese erlaubt. Aufgrund der Mikro- und Nanostruktur können die Implantate rasch und zuverlässig in das Knorpel- und Knochengewebe einwachsen, wie bereits anhand des Zellkultursubstrates beschrieben. Hierdurch können die Bildung von fibrösem Kapselgewebe und somit schmerzhafte Gewebeverhärtungen, Dislokationen oder Abstoßungsreaktionen verhindert werden.

Nachfolgend soll ein weiteres Ausführungsbeispiel für die erfindungsgemäßen Formwerkzeuge und die damit erzeugten Kunststoffbauteile dargestellt werden. Das Formwerkzeug enthält eine Aluminiumlegierung, in welche mittels Lasermaterialbearbeitung ein Gitter aus waagrechten und senkrechten Gräben eingebracht wird. Diese Gräben sorgen dafür, dass beim anschließenden Abformen Stege gleicher Dimension entstehen. Die mittels Lasermaterialbearbeitung erzeugten Gräben sind jeweils 50 µm breit und 100 µm tief. Der Abstand der einzelnen Gräben beträgt jeweils 50 µm. hierdurch wird die Oberfläche des Formwerkzeugs bzw. des später erzeugten Kunststoffbauteils bereits um einen Faktor 5 gegenüber der durch die geometrischen Abmessungen des Kunststoffbauteils definierten Oberfläche vergrößert.

Mit der anschließenden Nanostrukturierung werden durch anodische Oxidation zylindrische, hexagonal angeordnete Vertiefungen mit einem Durchmesser von 100 Nanometern, einer Tiefe von 500 Nanometer, sowie einem Porenfüllfaktor von 50 % auf die bereits durch die Mikrostruktur vergrößerte Oberfläche aufgebracht. Der Porenfüllfaktor bezeichnet dabei den Anteil der Porenfläche an der Gesamtfläche. Die Nanostrukturierung bedeckt die gesamte Oberfläche des Formwerkzeugs, einschließlich der Begrenzungsflächen der im vorangehenden Verfahrensschritt erzeugten Mikrostrukturierung. Hierdurch wird die Oberfläche zusätzlich um einen Faktor 10 vergrößert, so dass die Gesamtvergrößerung der Oberfläche durch die Strukturierung etwa das 50-fache der ursprünglich planen Oberfläche beträgt.

Selbstverständlich ist die Erfindung nicht auf die in den Figuren dargestellten Ausführungsformen beschränkt. Die vorstehende Beschreibung ist daher nicht als beschränkend sondern als erläuternd anzusehen. Soweit die Ansprüche und die vorstehende Beschreibung "erste" Und "zweite" Merkmale definieren, so dient diese Bezeichnung der Unterscheidung zweier gleichartiger Merkmale, ohne eine Rangfolge festzulegen.

## Patentansprüche

1. Verfahren zur Herstellung einer Oberflächenstrukturierung (1) auf einem Formwerkzeug (2), wobei in einem Verfahrensschritt erste Strukturelemente (11) durch Laserstrukturierung erzeugt werden,
und im Anschluss an die Laserstrukturierung in einem weiteren Verfahrensschritt zweite Strukturelemente (12) durch anodische Oxidation erzeugt werden, wobei die zweiten Strukturelemente (12) kleiner sind als die ersten Strukturelemente (11) und wobei durch Tempern ein zumindest teilweises Umsetzen von γ-Aluminiumoxid in α-Aluminiumoxid an der Oberfläche des Formwerkzeugs erfolgt.

2. Verfahren nach Anspruch 1, **dadurch gekennzeichnet, dass** die ersten Strukturelemente (11) eine laterale Ausdehnung von etwa 0,5 µm bis etwa 500 µm aufweisen oder
dass die ersten Strukturelemente (11) eine laterale Ausdehnung von etwa 10 µm bis etwa 100 µm aufweisen oder dass die ersten Strukturelemente (11) eine laterale Ausdehnung von etwa 15 µm bis etwa 25 µm aufweisen.

3. Verfahren nach Anspruch 1 oder 2, **dadurch gekennzeichnet, dass** die ersten Strukturelemente (11) eine Höhe von etwa 0,5 µm bis etwa 50 µm aufweisen oder
dass die ersten Strukturelemente (11) eine Höhe von etwa 1 µm bis etwa 10 µm aufweisen oder
dass die ersten Strukturelemente (11) eine Höhe von etwa 5 µm bis etwa 200 µm aufweisen.

4. Verfahren nach einem der Ansprüche 1 oder 3, **dadurch gekennzeichnet, dass** das Formwerkzeug (2) ein Metall oder eine Legierung enthält oder daraus besteht

5. Verfahren nach einem der Ansprüche 1 bis 4, **dadurch gekennzeichnet, dass** das Formwerkzeug Aluminium und/oder Titan enthält oder daraus besteht.

6. Verfahren nach einem der Ansprüche 1 bis 5, **dadurch gekennzeichnet, dass** die anodische Oxidation zur Erzeugung der zweiten Strukturelemente (12) in einem mehrstufigen Verfahren durchgeführt wird, enthaltend folgende Schritte:
- eine erste anodische Oxidation
- zumindest teilweises Entfernen einer Oxidschicht durch nasschemisches Ätzen
- zumindest eine zweite anodische Oxidation
- optional Öffnen der in den vorhergehenden Schritten entstandenen Poren.

7. Verfahren nach einem der Ansprüche 1 bis 6, weiterhin enthaltend den folgenden Schritt:
Elektropolieren der Oberfläche (21) nach Durchführung der Laserstrukturierung und vor der Erzeugung der zweiten Strukturelemente (12).

8. Verfahren nach einem der Ansprüche 1 bis 7, **dadurch gekennzeichnet, dass** weiterhin enthaltend den folgenden Schritt:
Tempern des Formwerkzeugs bei einer Temperatur von etwa 800°C bis etwa 1300°C oder
Tempern des Formwerkzeugs bei einer Temperatur von etwa 800°C bis etwa 1300°C in einer Schutzgasatmosphäre.

9. Verfahren nach einem der Ansprüche 1 bis 8, weiterhin enthaltend den folgenden Schritt:
Abscheiden einer Antihaftbeschichtung oder
Abscheiden einer Antihaftbeschichtung mittels PE-CVD und/oder
Abscheiden einer Antihaftbeschichtung, welche ein Plasmapolymer enthält oder daraus besteht und/oder Abscheiden einer Antihaftbeschichtung, welche eine Dicke von etwa 5 nm bis etwa 30 nm aufweist.

## Claims

1. Process for the production of surface structuring (1) on a mould (2), where in a step of the process initial structure elements (11) are produced by laser structuring, and the laser structuring is followed in a further step of the process by production of second structure elements (12) by anodic oxidation, where the second structure elements (12) are smaller than the initial structure elements (11) and where at least partial conversion of γ-aluminium oxide into α-aluminium oxide is achieved at the surface of the mould by tempering.

2. Process according to Claim 1, **characterized in that** the lateral dimension of the initial structure elements (11) is about 0.5 µm to about 500 µm, or
**in that** the lateral dimension of the initial structure elements (11) is about 10 µm to about 100 µm, or
**in that** the lateral dimension of the initial structure elements (11) is about 15 µm to about 25 µm.

3. Process according to Claim 1 or 2, **characterized in that** the height of the initial structure elements (11) is about 0.5 µm to about 50 µm, or
**in that** the height of the initial structure elements (11) is about 1 µm to about 10 µm, or
**in that** the height of the initial structure elements (11) is about 5 µm to about 200 µm.

4. Process according to Claim 1 or 3, **characterized in that** the mould (2) comprises, or consists of, a metal or an alloy.

5. Process according to any of Claims 1 to 4, **characterized in that** the mould comprises, or consists of, aluminium and/or titanium.

6. Process according to any of Claims 1 to 5, **characterized in that** the anodic oxidation for the production of the second structure elements (12) is carried out in a multistage process comprising the following steps:
- an initial anodic oxidation
- at least partial removal of an oxide layer by wet chemical etching
- at least one second anodic oxidation
- optionally opening of the pores produced in the preceding steps.

7. Process according to any of Claims 1 to 6, moreover comprising the following step:
electropolishing of the surface (21) after the laser structuring and before production of the second structure elements (12).

8. Process according to any of Claims 1 to 7, moreover comprising the following step:
tempering of the mould at a temperature of about 800°C to about 1300°C or
tempering of the mould at a temperature of about 800°C to about 1300°C in an inert gas atmosphere.

9. Process according to any of Claims 1 to 8, moreover comprising the following step:
deposition of an antiadhesive coating or
deposition of an antiadhesive coating by means of PECVD and/or
deposition of an antiadhesive coating which comprises, or consists of, a plasma polymer and/or
deposition of an antiadhesive coating, the thickness of which is about 5 nm to about 30 nm.

## Revendications

1. Procédé de réalisation d'une structuration de surface (1) sur un outil de moulage (2),
dans lequel
dans une étape de procédé, des premiers éléments de structure (11) sont réalisés par structuration au laser et
à la suite de la structuration au laser, dans une autre étape de procédé, des seconds éléments de structure (12) sont réalisés par oxydation anodique, les seconds éléments de structure (12) étant plus petits que les premiers éléments de structure (11), et une transformation au moins partielle de l'oxyde d'aluminium y en oxyde d'aluminium α ayant lieu par recuit à la surface de l'outil de moulage.

2. Procédé selon la revendication 1,
**caractérisé en ce que**
les premiers éléments de structure (11) ont une extension latérale d'environ 0,5 µm à environ 500 µm ou
les premiers éléments de structure (11) ont une extension latérale d'environ 10 µm à environ 100 µm ou
les premiers éléments de structure (11) ont une extension latérale d'environ 15 µm à environ 25 µm.

3. Procédé selon la revendication 1 ou 2,
**caractérisé en ce que**
les premiers éléments de structure (11) ont une hauteur d'environ 0,5 µm à environ 50 µm ou
les premiers éléments de structure (11) ont une hauteur d'environ 1 µm à environ 10 µm ou
les premiers éléments de structure (11) ont une hauteur d'environ 5 µm à environ 200 µm.

4. Procédé selon l'une des revendications 1 ou 3,
**caractérisé en ce que**
l'outil de moulage (2) contient ou consiste en un métal ou un alliage.

5. Procédé selon l'une des revendications 1 à 4,
**caractérisé en ce que**
l'outil de moulage contient ou consiste en aluminium et/ou en titane.

6. Procédé selon l'une des revendications 1 à 5,
**caractérisé en ce que**
l'oxydation anodique pour réaliser les seconds éléments de structure (12) est mise en oeuvre par un procédé à plusieurs étapes, comprenant les étapes suivantes consistant à :
- réaliser une première oxydation anodique,
- enlever au moins partiellement une couche d'oxyde par attaque chimique par voie humide,
- réaliser au moins une seconde oxydation anodique,
- ouvrir optionnellement les pores formés dans les étapes précédentes.

7. Procédé selon l'une des revendications 1 à 6,
comprenant en outre l'étape suivante consistant à :
réaliser un électro-polissage de la surface (21) après la réalisation de la structuration au laser et avant la réalisation des seconds éléments de structure (12).

8. Procédé selon l'une des revendications 1 à 7,
**caractérisé en ce qu'**il comprend en outre l'étape suivante consistant à :
recuire l'outil de moulage à une température d'environ 800 °C à environ 1300 °C, ou
recuire l'outil de moulage à une température d'environ 800 °C à environ 1300 °C sous une atmosphère de gaz de protection.

9. Procédé selon l'une des revendications 1 à 8,
**caractérisé en ce qu'**il comprend en outre l'étape suivante consistant à :
déposer un revêtement anti-adhérent ou
déposer un revêtement anti-adhérent par PE-CVD, et/ou
déposer un revêtement anti-adhérent qui contient ou est constitué en un polymère de plasma et/ou
déposer un revêtement anti-adhérent qui présente une épaisseur d'environ 5 nm à environ 30 nm.
